Europäisches Patentamt

European Patent Office

Office européen des brevets

(19)

(11) **EP 0 870 333 B1**

(12) **EUROPÄISCHE PATENTSCHRIFT**

(45) Veröffentlichungstag und Bekanntmachung des Hinweises auf die Patenterteilung:
**04.12.2002  Patentblatt 2002/49**

(51) Int Cl.[7]: **H01L 31/0232**, H01L 31/052

(21) Anmeldenummer: **96919530.4**

(86) Internationale Anmeldenummer:
**PCT/DE96/00812**

(22) Anmeldetag: **10.05.1996**

(87) Internationale Veröffentlichungsnummer:
**WO 96/036989 (21.11.1996 Gazette 1996/51)**

(54) **OPTISCHE LINSEN-/DETEKTORANORDNUNG**

OPTICAL LENS/DETECTOR ARRANGEMENT

SYSTEME OPTIQUE LENTILLE/DETECTEUR

(84) Benannte Vertragsstaaten:
**BE CH DE FR GB IT LI NL SE**

(30) Priorität: **18.05.1995  DE 19518303**

(43) Veröffentlichungstag der Anmeldung:
**14.10.1998  Patentblatt 1998/42**

(73) Patentinhaber: **Forschungszentrum Jülich GmbH**
**52425 Jülich (DE)**

(72) Erfinder:
• **MARSO, Michel**
**D-52428 Jülich (DE)**
• **SCHELTEN, Jakob**
**D-52428 Jülich (DE)**

• **VAN DER HART, André**
**D-52428 Jülich (DE)**

(56) Entgegenhaltungen:
WO-A-91/02380              US-A- 4 016 416
US-A- 4 072 541

• **PATENT ABSTRACTS OF JAPAN vol. 017, no. 518 (E-1434), 17.September 1993 & JP 05 136446 A (NIKKO KYODO CO LTD), 1.Juni 1993,**
• **PATENT ABSTRACTS OF JAPAN vol. 008, no. 206 (E-267), 20.September 1984 & JP 59 090964 A (NIPPON DENKI KK), 25.Mai 1984,**
• **PATENT ABSTRACTS OF JAPAN vol. 011, no. 286 (E-541), 16.September 1987 & JP 62 084572 A (NEC CORP), 18.April 1987,**

**Beschreibung**

Die vorliegende Erfindung betrifft eine optische Linsen-/Detektoranordnung gemäß Oberbegriff von Anspruch 1.

Aus JP-A-05 136 446 ist ein Halbleiter-Photodetektor bekannt mit einem strahlungsdurchlässigen Substrat, auf dessen Lichteintrittseite eine strahlungsbeugende und/oder brechende Linsenschicht ausgebildet ist. Auf der entgegengesetzten Seite ist eine Reflexionsschicht 30 ohne strahlungsbrechende und/oder beugende Eigenschaften ausgebildet. Eine auf der Lichteintrittseite einfallende Strahlung wird eintrittsseitig gebeugt und/oder gebrochen und auf die Reflexionsschicht abgelenkt und von der Reflexionsschicht wiederum auf eine Detektorschicht an der Lichteintrittsseite zurückreflektiert.

Aus JP-A-62 084 572 ist ein Photodektor bekannt, mit einem lichtdurchlässigen Substrat, auf dessen Lichteintrittsseite eine Detektorschicht ausgebildet ist und auf dessen entgegengesetzter Seite eine strahlungsbeugende und/oder brechende Reflexionsschicht ausgebildet ist. Die auf der Lichteintrittsseite einfallende Strahlung tritt ohne beugende und/oder brechende Wirkung in das Substrat ein und trifft auf die Reflexionsschicht. Von dieser wird die Strahlung mit beugender und/oder brechender Wirkung reflektiert und auf die Detektorschicht konzentriert.

Auch aus PCT/US90/04388 (WO-A-9102380) ist eine Linsen-/Detektoranordnung bekannt und weist ein strahlungsdurchlässiges Substrat auf, auf dessen Strahlungseintrittsseite (Rückseite) eine binäre optische Linse und auf dessen gegenüberliegender Seite ein Photodetektor-Array (Vorderseite) ausgebildet ist. Das Photodetektor-Array liegt in der Brennebene der binären optischen Linse, so daß eine von einem Objekt an der Rückseite einfallende Strahlung durch die binäre optische Linse auf das Photodetektor-Array fokussiert wird.

Die funktionellen Einheiten der binären optischen Linse sowie auch des Photodetektor-Arrays sind durch Materialabtragung oder -aufbringung jeweils auf zwei Seiten des Substrats monolithisch ausgebildet. Durch den Aufbau des in PCT/US90/04388 beschriebenen Standes der Technik liegt die Oberflächenstruktur der binären optischen Linse an der rückseitigen Oberfläche des Substrats und das Photodetektor-Array an der vorderseitigen Oberfläche des Substrats jeweils frei und gegenüber äußeren Einflüssen ungeschützt.

Das beiderseitige freiliegende Ausbilden einer solchen binären optischen Linse sowie eines solchen Photodetektor-Arrays führt auch bei der weiteren Handhabung der Anordnungseinheit leicht zu Beschädigungen, wenn die Anordnungseinheit mit ihrer Vorderseite (Seite des Photodetektor-Arrays) positioniert werden soll.

In Fällen, in denen aus konstruktiven Gründen das Photodetektor-Array vorzugsweise so ausgerichtet sein sollte, daß die zu detektierende Strahlung an seiner Seite, der Vorderseite, einfällt, ist die Anordnungseinheit des Standes der Technik nicht verwendbar.

Auch das in der oben genannten PCT/US90/04388 beschriebene Verfahren zur Herstellung einer binären optischen Linse auf einem Substrat eines Photodetektor-Arrays führt zu den bereits ausgeführten Nachteilen.

Die Aufgabe der vorliegenden Erfindung ist daher, eine optische Linsen/Detektoranordnung zu schaffen, die weniger anfällig gegenüber äußeren Einflüssen und vielseitig einsetzbar ist sowie durch verbesserte Sammeleigenschaften vielseitiger einsetzbar ist.

Die Aufgabe wird durch die Merkmale des kennzeichnenden Teils von Anspruch 1 gelöst.

Mit der erfindungsgemäßen Anordnung ist die Strahlungs-Ablenkeinrichtung monolithisch an einer anderen Seite des Substrats ausgebildet als der Strahlungseintrittsseite. Statt dessen ist die Vorderseite des Substrats mit der Strahlungs-Detektorschicht erfindungsgemäß auch die Strahlungseintrittsseite und so zu der Reflexionsschicht ausgerichtet, daß eine in das Substrat eingetretene Strahlung an der Reflexionschicht auf die Strahlungs-Detektorschicht reflektierbar ist Eine solche Reflexionsrichtung der Strahlung erfolgt durch eine linsentypische Formgebung der Reflexionsschicht mit lichtbrechender oder-beugender Wirkung (Linsenwirkung), zusätzlich zu der reflektierenden Wirkung. Der Wirkungsbereich der Reflexionsschicht liegt nicht an der äußeren, sondern an der inneren Oberfläche derselben, so daß äußere Einwirkungen auf die äußere Oberfläche die Funktionsfähigkeit der Reflexionsschicht und damit der Strahlungs-Ablenkeinrichtung nicht negativ beeinflussen können. Die optische Linsen-/Detektoranordnung weist somit lediglich eine "empfindliche" Oberfläche auf und ist daher wesentlich robuster zu handhaben.

Wenn die Reflexionsschicht eine strahlungsbrechende und/oder -beugende Wirkung hat, wie bereits vorstehend als Möglichkeit erwähnt, da dadurch eine in etwa horizontale Schichtfolge der erfindungsgemäßen Anordnung möglich ist, wird die Herstellung wesentlich vereinfacht.

Eine zusätzliche Linsenschicht auf der Strahlungseintrittsseite läßt in vorteilhafter Weise zu, die Ausbildung der Reflexionsschicht zu variieren. So kann die Reflexionsschicht bedarfsweise linsentypisch mit strahlungsbrechender und/oder -beugender Wirkung und dennoch im wesentlichen horizontal ausgebildet sein. Die zweifache Linsenwirkung kann für unterschiedlichste Einsatzzwecke genutzt werden.

Ein weiterer Vorteil liegt zum Beispiel auch darin, daß die optische Linsen/-Detektoranordnung gemäß Anspruch 2 dazu verwendet werden kann, die Richtung eines Lichtstrahles zu detektieren. Wenn diese optische Linsen-/Detektoranordnung darüber hinaus gemäß Anspruch 3 weitergebildet ist, wird ein Photodetektor mit vorteilhaft großer Empfindlichkeit bei niedrigem Dunkelstrom und kleiner Kapazität erhalten.

Eine optische Linsen-/Detektoranordnung gemäß Anspruch 4 hat den Vorteil, daß mit dieser das Bild eines Objektes detektierbar ist.

Mit einer Zuordnung "Detektor-Linse" gemäß Anspruch 5 kann die Einsatz- und Leistungsfähigkeit der erfindungsgemäßen Anordnung bedarfsweise verändert werden.

So kann mit der Ausführung gemäß Anspruch 6 die Lage eines Objektes im Raum durch Triangulation ermittelt werden. Mit der Ausführung gemäß Anspruch 7 erkennen dagegen alle "Detektor-Linse"-Kombinationen im wesentlichen dasselbe Bild. Die Abbildung eines Objektes kann durch Erzeugen einer unterschiedlichen Wellenlängenempfindlichkeit der verschiedenen Kombinationen gemäß Anspruch 8, z. B. durch vorgeschaltete oder aufgebrachte Farbfilter oder durch wellenlängenabhängige Linsenwirkung, als Farbaufnahme oder allgemein im ortsabhängigen Spektrum erfolgen.

Mit der Ausführung gemäß Anspruch 9 kann die Auflösung des gesamten Systems gegenüber einer einzelnen Kombination vergrößert werden.

Wenn die Strahlungs-Detektorschicht als Solarzelle und die Strahlungs-Ablenkeinrichtung als eine Vielzahl von Sammellinsen ausgebildet ist, gemäß Anspruch 10, kann der Wirkungsgrad der erfindungsgmäßen Anordnung vergrößert werden. Die einfallende Strahlung trifft nicht gleichmäßig auf die Solarzelle, sondern es werden nur kleine Bereiche mit sehr hoher Strahlungsintensität angeregt. Der Wirkungsgrad von Solarzellen steigt aber mit zunehmender Strahlungsintensität, so daß durch die erfindungsgemäße Bündelung der Strahlung auf kleine Bereiche der Wirkungsgrad der gesamten Solarzelle vergrößert wird.

Die erfindungsgemäße Anordnung kann zudem auch in vorteilhafter Weise zur optischen Bildverarbeitung eingesetzt werden, wenn die Strahlungs-Ablenkeinrichtung gemäß Anspruch 11 als Hologramm ausgebildet ist.

Ein Ausführung gemäß Anspruch 12, in der das Hologramm als Linse mit mehreren Brennpunkten ausgebildet ist, ermöglicht auch den Einsatz der erfindungsgemäßen Anordnung zur synchronen Takterzeugung in komplexen Halbleiterschaltungen.

Eine Ausführungsform der vorliegenden Erfindung wird im Folgenden anhand der Zeichnungen näher beschrieben. Es zeigen:

Fig. 1    eine schematische Ansicht einer optischen Linsen-/Detektoranordnung gemäß vorliegender Erfindung;

Fig. 2    eine schematische Ansicht einer optischen Linsen-/Detektoranordnung des Standes der Technik ohne eine Linsenschicht an der Lichteintrittsseite;

Fig. 3    eine schematische Ansicht einer optischen Linsen-/Detektoranordnung des Standes der Technik mit einer nicht strahlungsbrechenden und/oder beugenden Wirkung;

Fig. 4    eine schematische Draufsicht auf eine als Zonenplatte ausgebildete Linsenschicht gemäß vorliegender Erfindung;

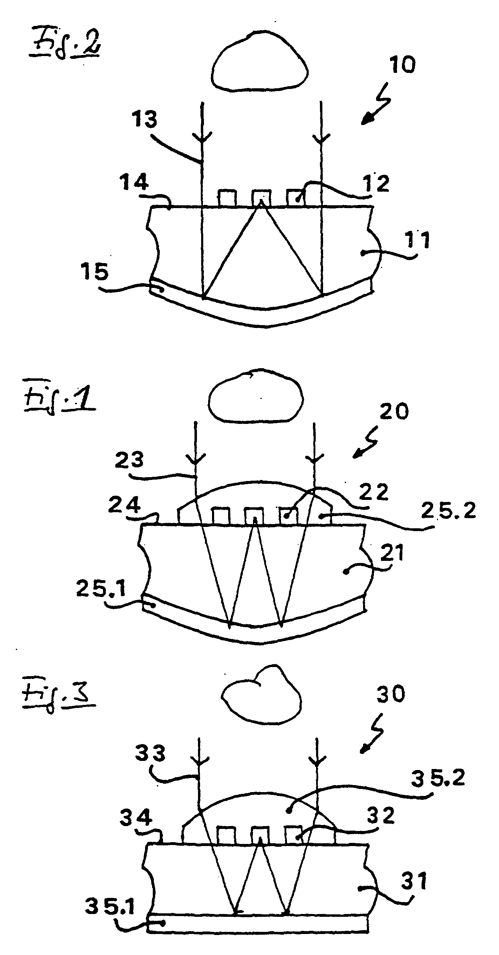

In Fig. 1 ist eine schematische Ansicht einer optischen Linsen-/Detektoranordnung 20 gemäß der vorliegenden Erfindung dargestellt. Auf einem Substrat 21 ist eine Detektorschicht 22 ausgebildet. Das Substrat 21 und die Detektorschicht 22 bestehen aus einem Material, wie es unten im Zusammenhang mit entsprechenden Bauteilen 11 und 12 beschrieben wird. Eine Strahlung 23 tritt auf einer Strahlungseintrittsseite 24, auf der die Detektorschicht 22 ausgebildet ist, in das Substrat 21 ein und wird an einer Strahlungs-Ablenkeinrichtung 25.1 reflektiert und gesammelt. Die Strahlungs-Ablenkeinrichtung 25.1 hat in dieser erfindungsgemäßen Ausführungsform also nicht nur reflektierende, sondern auch lichtbeugende und/oder -brechende Wirkung.

Im Unterschied zu der in Fig. 2 dargestellten Ausführungsform des Standes der Technik umfaßt in der vorliegenden Erfindung die Strahlungs-Ablenkeinrichtung 25.1 zusätzlich eine Linsenschicht 25.2 auf der Strahlungseintrittsseite 24. In der dargestellten erfindungsgemäßen Ausführungsform ist die Detektorschicht 22 zwischen der Linsenschicht 25.2 und der Reflektionsschicht 25.1 mit Linsenwirkung angeordnet. Die zweifache Ablenkung der einfallenden Strahlung 23 verbessert die Sammeleigenschaften der optischen Linsen/Detektoranordnung 20.

In Fig. 2 ist eine schematische Ansicht einer optischen Linsen-/Detektoranordnung 10 des Standes der Technik, ohne eine zusätzliche Linsenschicht 25.2 dargestellt. Darüber hinaus ist die Linsen-/Detektoreinrichtung 10 identisch mit der erfindungsgemäßen Linsen/Detektoranordnung 20 aus Fig. 1. Dies gilt insbesondere für die im Folgenden in Verbindung mit Fig. 2 beschriebenen Merkmale. Ein Substrat 11 ist aus einem für die Wellenlänge der zu detektierenden Strahlung transparenten Material ausgebildet. Ein solches Material ist z. B. Glas, Quarz, Saphir, Kunststoff mit ausreichender Transparenz bei der Wellenlänge des zu detektierenden Lichtes, ein Halbleiter mit hoher Bandlükke, Si, InP oder GaAs. Auf dem Substrat 11 ist eine Detektorschicht 12 monolithisch ausgebildet. Die Detektorschicht 12 kann aus einem einzelnen Strahlungsdetektor, aus mehreren Strahlungsdetektoren, aus einem Detektorarray oder aus mehreren Detektorarrays bestehen oder aber bedarfsweise auch als Solarzelle ausgeführt sein. Das mit der Detektorschicht 12 versehene Substrat 11 ist gegenüber einen einfallenden Strahlung 13 so ausgerichtet, daß die Detektorschicht 12 auf der Strahlungseintrittsseite 14 liegt.

Die Detektorschicht 12 kann bedarfsweise aus einer pn-Halbleiterdiode, einer pin-Halbleiterdiode, einer Schottkydiode, einer MSM-Diode, mehreren der genannten Bauelemente auch in Kombination oder einem CCD-Array bestehen.

Auf der der Detektorschicht 12 bzw. der Strahlungseintrittsseite 14 gegenüberliegenden Seite ist auf dem Substrat 11 eine Strahlungs-Ablenkeinrichtung 15 als Reflexionsschicht ausgebildet. Die Reflexionsschicht 15 hat neben der reflektierenden Wirkung auch eine strahlungsbrechende und/oder -beugende Wirkung. Eine solche Linsenwirkung kann z. B. durch Zonenplatten (siehe Fig. 4) erzeugt werden, die durch Materialabtragung und/oder - aufbringung hergestellt werden können.

Die Strahlungs-Ablenkeinrichtung 15 kann bedarfsweise aber auch als Sammellinse, eine Vielzahl von Sammellinsen oder als Hologramm mit einem oder mehreren Brennpunkten ausgebildet sein.

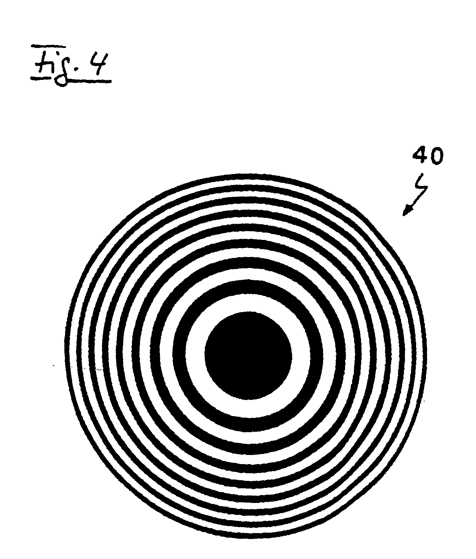

In Fig. 3 ist eine schematische Ansicht einer optischen Linsen-/Detektoranordnung 30 des Standes der Technik, mit einer Reflexionsschicht 35.1 ohne strahlungsbrechender und/oder beugender Wirkung. Ein Substrat 31 und eine Detektorschicht 32 sind entsprechend der zu Fig. 1 und Fig. 2 beschriebenen Linsen-/Detektoranordnungen 20, 10 hergestellt und bestehen jeweils aus den bereits im Zusammenhang mit Fig. 2 für die entsprechenden Bauteile 11 und 12 beschriebenen Materialien. Auch die Zuordnung der Detektorschicht 32 zu einer einfallenden Strahlung 33, das heißt, einer Strahlungseintrittsseite 34, entspricht der Zuordnung in Fig. 1 und Fig. 2. Wie in Fig. 1 ist auf einer Seite eine Reflexionsschicht 35.1 und auf der gegenüberliegenden Strahlungseintrittsseite 34 eine Linsenschicht 35.2 ausgebildet. Der Unterschied gegenüber der vorliegenden Erfindung gemäß Fig. 1 und dem Stand der Technik aus Fig. 2 besteht in einer planaren Ausbildung der Reflexionsschicht 35.1, das heißt, ohne lichtbrechende und/oder -beugende Wirkung.

In Fig. 4 ist eine schematische Ansicht einer Linsenausführung als Zonenplatte 40 dargestellt. Die als Zonenplatte 40 monolithisch integrierte Linse soll eine Auflösung haben, die nach folgender Gleichung berechnet wird:

$$a = 1.22 \left(\frac{\lambda}{n}\right)\left(\frac{h}{d}\right)$$

In dieser Gleichung ist $\lambda$ die Wellenlänge des verwendeten Lichts, **n** der Brechungsindex des Substrats, **h** die Substratdicke, die gleichzeitig die Brennweite der Linse ist, und **d** der Durchmesser der Linse. Mit den typischen Werten von $\lambda$ = 1.55 $\mu$m, n = 3, h = 0,3 mm und d = 0.1 mm ergibt sich die Auflösung von a = 2 $\mu$m. Dies ist eine physikalische Auflösungsgrenze, die unabhängig von der Realisierung einer Linse besteht. Damit die Zonenplatte 40 dieses Auflösungsvermögen erreicht, muß die Linsenfläche von 0,1 mm Durchmesser mit 17 konzentrischen Ringen belegt werden, wobei jeder zweite Ring aus einer strahlungsabsorbierenden, einer strahlungsreflektierenden oder einer, die Phase der Strahlung um $\pi$ drehenden Schicht besteht. Diese Eigenschaften können mit metallischen bzw. dielektrischen Schichten, der Dicken weniger als 0.25 um betragen, realisiert werden. Die Breiten der Ringe nehmen mit wachsendem Durchmesser monoton ab. Die kleinste Ringbreite ist bei der Referenzlinse 1.5 $\mu$m, das heißt, solche Zonenplatten 40 sind mit der optischen Lithographie herstellbar.

**Patentansprüche**

1. Optische Linsen-/Detektoranordnung mit zugeordneter Strahlungseintrittsseite, mit einer auf einem strahlungsdurchlässigen Substrat strahlungseintrittsseitig monolithisch ausgebildeten Strahlungs-Detektorschicht und mit einer strahlungsbrechenden und/oder beugenden Reflexionsschicht, wobei die eintretende Strahlung in Richtung auf die Strahlungs-Detektorschicht gebündelt wird, **dadurch gekennzeichnet,** **daß** eine strahlungsbrechende und/oder beugende Linsenschicht (25.2) mit der Strahlungs-Detektorschicht (22) auf einer Schichtebene ausgebildet ist und mit der Reflexionsschicht (25.1) eine in dem Substrat monolithisch ausgebildete Strahlungs-Ablenkeinrichtung (25.1, 25.2) bildet, die eine auf der Strahlungseintrittsseite (24) eintretende Strahlung zweifach ablenkt, wobei die Strahlungs-Detektorschicht (22) in der Brennebene der Strahlungs-Ablenkeinrichtung (25.1, 25.2) ausgebildet ist.

2. Optische Linsen-/Detektoranordnung nach Anspruch 1, **dadurch gekennzeichnet,** **daß** die Strahlungs-Ablenkeinrichtung (25.1, 25.2) derart ausgebildet ist, daß diese die Wirkung einer Sammellinse hat, und die Strahlungs-Detektorschicht (22) als ein einzelner Photodetektor ausgebildet ist.

3. Optische Linsen-/Detektoranordnung nach Anspruch 2, **dadurch gekennzeichnet,** **daß** die aktive Fläche der Strahlungs-Ablenkeinrichtung (25.1, 25.2) ein Vielfaches der aktiven Fläche des Photodetektors (22) ist.

4. Optische Linsen-/Detektoranordnung nach Anspruch 1, **dadurch gekennzeichnet,** **daß** die Strahlungs-Ablenkeinrichtung (25.1, 25.2) derart ausgebildet ist, daß diese die Wirkung einer Sammellinse aufweist, und die Strahlungs-Detektorschicht (22) als Photodetektor-Array ausgebildet ist.

5. Optische Linsen-/Detektoranordnung nach Anspruch 1,
   **dadurch gekennzeichnet,**
   **daß** die Strahlungs-Detektorschicht (22) mehrere einzelne Photodetektoren und/oder Photodetektor-Arrays umfaßt, wobei jedem der Photodetektoren und Photodetektor-Arrays ein Bereich der Strahlungs-Ablenkeinrichtung (25.1, 25.2) zugeordnet ist, derart, daß eine zugeordnete Kombination gebildet wird.

6. Optische Linsen-/Detektoranordnung nach Anspruch 5,
   **dadurch gekennzeichnet,**
   **daß** der Abstand der jeweils zugeordneten Kombinationen zueinander in etwa dem Abstand zwischen der Strahlungs-Ablenkeinrichtung (25.1, 25.2) und einem Objekt entspricht.

7. Optische Linsen-/Detektoranordnung nach Anspruch 5,
   **dadurch gekennzeichnet,**
   **daß** der Abstand der jeweils zugeordneten Kombinationen zueinander kleiner als der Abstand zwischen der Strahlungs-Ablenkeinrichtung (25.1, 25.2) und einem Objekt ist.

8. Optische Linsen-/Detektoranordnung nach Anspruch 7,
   **dadurch gekennzeichnet,**
   **daß** die jeweils zugeordneten Kombinationen eine unterschiedliche Wellenlängenempfindlichkeit haben.

9. Optische Linsen-/Detektoranordnung nach einem der Ansprüche 5 bis 8,
   **dadurch gekennzeichnet,**
   **daß** die Strahlungs-Detektorschicht (22) gegenüber der optischen Achse der Strahlungs-Ablenkeinrichtung (25.1, 25.2) in jeder zugeordneten Kombination unterschiedlich positioniert ist.

10. Optische Linsen-/Detektoranordnung nach Anspruch 1,
    **dadurch gekennzeichnet,**
    **daß** die Strahlungs-Detektorschicht (22) als Solarzelle und die Strahlungs-Ablenkeinrichtung (25.1, 25.2) als eine Vielzahl von Sammellinsen ausgebildet ist.

11. Optische Linsen-/Detektoranordnung nach Anspruch 1,
    **dadurch gekennzeichnet,**
    **daß** die Strahlungs-Ablenkeinrichtung (25.1, 25.2) als Hologramm ausgebildet ist.

12. Optische Linsen-/Detektoranordnung nach Anspruch 11,
    **dadurch gekennzeichnet,**
    **daß** das Hologramm (25.1, 25.2) als Linse mit mehreren Brennpunkten ausgebildet ist.

13. Optische Linsen-/Detektoranordnung nach einem der vorstehenden Ansprüche,
    **dadurch gekennzeichnet,**
    **daß** die Strahlungs-Detektorschicht (22) aus wenigstens einem Bauelement der Gruppe pn-Halbleiterdiode; pin-Halbleiterdiode; Schottkydiode; MSM-Diode oder einer Kombination dieser Bauelemente oder aus einem CCD (charge-coupled device)-Array besteht.

14. Optische Linsen-/Detektoranordnung nach der vorstehenden Ansprüche,
    **dadurch gekennzeichnet,**
    **daß** das Substrat (21) aus einem Material der Gruppe Halbleitermaterial, Glas, Quarz; Saphir; lichtdurchlässiger Kunststoff besteht.

15. Optische Linsen-/Detektoranordnung nach einem der vorstehenden Ansprüche,
    **gekennzeichnet durch**
    eine Kombination von Strahlungs-Detektorschicht (22) und Substrat (21) bestehend aus einer Materialkombination aus der Gruppe Halbleiter/Glas; Halbleiter/Quarz; Halbleiter/Saphir; Halbleiter/Kunststoff mit ausreichender Transparenz bei der Wellenlänge der zu detektierenden Strahlung; Halbleiter mit niedriger Bandlücke/Halbleiter mit hoher Bandlücke; $Si_xGe_{1-x}/Si$; Si/Glas; Si/Quarz; Si/Saphir; $Ga_{1-x}In_xAs/InP$; $Ca_{1-x}In_xAs/GaAs$.

16. Optische Linsen-/Detektoranordnung nach einem der vorstehenden Ansprüche,
    **dadurch gekennzeichnet,**
    **daß** die Reflexionsschicht (25.1) strukturiert ausgebildet ist und eine Phasenumkehr oder eine Lichtbrechung bewirkt.

17. Optische Linsen./Detektoranordnung nach einem der Ansprüche 1 bis 16,
    **dadurch gekennzeichnet,**
    **daß** die Linsenschicht (25.2) strukturiert ausgebildet ist und eine Phasenumkehr oder eine Lichtbrechung bewirkt.

18. Optische Linsen-/Detektoranordnung nach einem der vorstehenden Ansprüche,
    **dadurch gekennzeichnet,**
    **daß** die Strahlungs-Detektorschicht (22) zwischen der Linsenschicht (25.2) und der Reflexionsschicht (25.1) ausgebildet ist.

## Claims

1. An optical lens/detector arrangement with assigned radiation inlet side, with a radiation detector layer, which is designed monolithically on a radiation-permeable substrate on the radiation inlet side, and with a radiation-refractive and/or diffractive reflective layer, whereby the incoming radiation is focussed in the direction of the radiation detector layer,
   **characterized in that**
   a radiation-refractive and/or diffractive lens layer (25.2) is designed with the radiation detection device (22) on a layer plane and together with the reflective layer (25.1) forms a radiation deflection device (25.1, 25.2) designed monolithically in the substrate, which twice deflects the radiation detector layer (22) entering on the radiation inlet side (24), whereby the radiation detector layer (22) is designed in the focal plane of the radiation deflection device (25.1, 25.2).

2. The optical lens/detector arrangement as claimed in Claims 1,
   **characterised in that**
   the radiation deflection device (25.1, 25.2) has the effect of a convex lens and the radiation detector layer (22) is designed as a single photo detector.

3. The optical lens/detector arrangement as claimed in Claim 2,
   **characterised in that**
   the active surface of the radiation deflection device (25.1, 25.2) is a multiple of the active surface of the photo detector (22).

4. The optical lens/detector arrangement as claimed in Claim 1,
   **characterised in that**
   the radiation deflection device (25.1, 25.2) has the effect of a convex lens and the radiation detector layer (22) is designed as a photo detector array.

5. The optical lens/detector arrangement as claimed in Claim 1,
   **characterised in that**
   the radiation detector layer (22) comprises several single photo detectors and/or photo detector arrays, whereby each of the photo detectors or photo detector arrays is assigned an area of the radiation deflection device (25.1, 25.2).

6. The optical lens/detector arrangement as claimed in Claim 5,
   **characterised in that**
   the distance of each of the assigned combinations from one another corresponds to approximately the distance between the radiation deflection device (25.1, 25.2) and a lens.

7. The optical lens/detector arrangement as claimed in Claim 5,
   **characterised in that**
   the distance of each of the assigned combinations from one another is less than the distance between the radiation deflection device (25.1, 25.2) and a lens.

8. The optical lens/detector arrangement as claimed in Claim 7,
   **characterised in that**
   each of the assigned combinations has a different wavelength sensitivity.

9. The optical lens/detector arrangement as claimed in any one of Claims 5 to 8,
   **characterised in that**
   the radiation detector layer (22) is placed variously opposite the optical axis of the radiation deflection device (25.1, 25.2) in each assigned combination.

10. The optical lens/detector arrangement as claimed in Claim 1,
    **characterised in that**
    the radiation detector layer (22) is designed as a solar cell and the radiation deflection device (25.1, 25.2) is designed as a multiplicity of convex lenses.

11. The optical lens/detector arrangement as claimed in Claim 1,
    **characterised in that**
    the radiation deflection device (25.1, 25.2) is designed as a hologram.

12. The optical lens/detector arrangement as claimed in Claim 11,
    **characterised in that**
    the hologram (25.1, 25.2) is designed as a lens with several focal points.

13. The optical lens/detector arrangement as claimed in any one of the foregoing claims,
    **characterised in that**
    the radiation detector layer (22) comprises at least one structural element of the group of pn-semicondutor diodes; pin-semiconductor diodes; Schottky diodes; MSM diodes or a combination of these structural elements or comprises a CCD (charge-coupled device) array.

14. The optical lens/detector arrangement as claimed in any one of the foregoing claims,
    **characterised in that**
    the substrate (21) comprises a material of the group of semiconductor material; glass; quartz; sapphire; light-permeable synthetic material.

**15.** The optical lens/detector arrangement as claimed in any one of the foregoing claims,
**characterised by**
a combination of radiation detector layer (22) and substrate (21) comprising a material combination from the group of semiconductor/glass; semiconductor/quartz; semiconductor/ sapphire; semiconductor/synthetic with adequate transparency in the wavelength of the radiation to be detected; semiconductor with low band gap/semiconductor with high band gap; $Si_xGe_{1-x}$/Si; Si/glass; Si/quartz; Si/sapphire; $Ga_{1-x}In_xAs$/InP; $Ga_{1-x}In_xAs$/GaAs.

**16.** The optical lens/detector arrangement as claimed in any one of the foregoing claims,
**characterised in that**
the reflective layer (25.1) is designed as a structure and acts as phase reversal or light refraction.

**17.** The optical lens/detector arrangement as claimed in any one of Claims 1 to 16,
**characterised in that**
the lens layer (25.2) is designed as a structure and acts as phase reversal or light refraction.

**18.** The optical lens/detector arrangement as claimed in any one of the foregoing claims,
**characterised in that**
the radiation detector layer (22) is designed between the lens layer (25.2) and the reflective layer (25.1).

**Revendications**

**1.** Agencement détecteur optique à lentille avec un côté associé d'entrée de rayonnement, avec une couche détectrice de rayonnement configurée de manière monolithique sur un substrat laissant passer le rayonnement du côté de l'entrée du rayonnement et avec une couche réfléchissante réfractant et/ou infléchissant le rayonnement, le rayonnement entrant étant focalisé en direction de la couche détectrice de rayonnement,
**caractérisé en ce que**
une couche de lentille (25.2) réfractant et/ou infléchissant le rayonnement est configurée avec la couche détectrice de rayonnement (22) sur un plan feuilleté et forme avec la couche réfléchissante (25.1) un dispositif de diffraction de rayonnement (25.1, 25.2) configuré de manière monolithique dans le substrat, dispositif qui diffracte doublement un rayonnement entrant sur le côté d'entrée du rayonnement (24), la couche détectrice de rayonnement (22) étant formée dans le plan focal du dispositif de diffraction de rayonnement (25.1, 25.2).

**2.** Agencement détecteur optique à lentille selon la revendication 1,
**caractérisé en ce que**
le dispositif de diffraction de rayonnement (25.1, 25.2) est configuré de manière à ce que celui-ci ait l'effet d'une lentille convergente et que la couche détectrice de rayonnement (22) soit configurée comme un photo-détecteur individuel.

**3.** Agencement détecteur optique à lentille selon la revendication 2 ,
**caractérisé en ce que**
la surface active du dispositif de diffraction de rayonnement (25.1, 25.2) est un multiple de la surface active du photo-détecteur (22).

**4.** Agencement détecteur optique à lentille selon la revendication 1,
**caractérisé en ce que**
le dispositif de diffraction de rayonnement (25.1, 25.2) est configuré de manière à ce que celui-ci ait l'effet d'une lentille convergente et que la couche détectrice de rayonnement (22) est configurée comme un panneau photo-détecteur.

**5.** Agencement détecteur optique à lentille selon la revendication 1,
**caractérisé en ce que**
la couche détectrice de rayonnement (22) comprend plusieurs photo-détecteurs individuels et/ou panneaux photo-détecteurs, à chacun des photo-détecteurs et panneaux photo-détecteurs étant associée une zone du dispositif de diffraction de rayonnement (25.1, 25.2), de manière à former une combinaison associée.

**6.** Agencement détecteur optique à lentille selon la revendication 5,
**caractérisé en ce que**
l'écart entre les combinaisons respectivement associées équivaut approximativement à l'écart entre le dispositif de diffraction de rayonnement (25.1, 25.2) et un objet.

**7.** Agencement détecteur optique à lentille selon la revendication 5,
**caractérisé en ce que**
l'écart entre les combinaisons respectivement associées est inférieur à l'écart entre le dispositif de diffraction de rayonnement (25.1, 25.2) et un objet.

**8.** Agencement détecteur optique à lentille selon la revendication 7,
**caractérisé en ce que**
les combinaisons respectivement associées ont une sensibilité de longueur d'ondes différente.

**9.** Agencement détecteur optique à lentille selon une des revendication 5 à 8,

**caractérisé en ce que**

la couche détectrice de rayonnement (22) est positionnée différemment par rapport à l'axe optique du dispositif de diffraction de rayonnement (25.1, 25.2) dans chaque combinaison associée.

10. Agencement détecteur optique à lentille selon la revendication 1,
**caractérisé en ce que**
la couche détectrice de rayonnement (22) est configurée comme une cellule solaire et que le dispositif de diffraction de rayonnement (25.1, 25.2) est configuré comme une multitude de lentilles convergentes.

11. Agencement détecteur optique à lentille selon la revendication 1,
**caractérisé en ce que**
le dispositif de diffraction de rayonnement (25.1, 25.2) est configuré comme un hologramme.

12. Agencement détecteur optique à lentille selon la revendication 11,
**caractérisé en ce que**
l'hologramme (25.1, 25.2) est configuré comme une lentille avec plusieurs points focaux.

13. Agencement détecteur optique à lentille selon une des revendications précédentes,
**caractérisé en ce que**
la couche détectrice de rayonnement (22) consiste en au moins un composant du groupe diode à semi-conducteurs pn ; diode à semi-conducteurs spin ; diode Schottky ; diode MSM ou une combinaison de ces composants ou un panneau CCD (charge-coupled device : circuit à couplage de charge).

14. Agencement détecteur optique à lentille selon une des revendications précédentes,
**caractérisé en ce que**
le substrat (21) consiste en une matière du groupe matière de semi-conducteurs,erre, quartz ; saphir ; matière plastique transparente.

15. Agencement détecteur optique à lentille selon une des revendications précédentes,
**caractérisé par**
une combinaison de la couche détectrice de rayonnement (22) et du substrat (21) consistant en une combinaison de matière du groupe semi-conducteur/verre; semiconducteur/quartz ; semiconducteur/saphir ; semi-conducteur/matière plastique avec une transparence suffisante à la longueur d'ondes du rayonnement à détecter ; semiconducteur à basse structure de bande/semiconducteur à haute structure de bande ; $Si_xGe_{1-x}$ /Si ; Si/verre ; Si/quartz ; Si/saphir, $Ga_{1-x}In_x$-As/InP ; $Ga_{1-x}In_x$-As/GaAs.

16. Agencement détecteur optique à lentille selon une des revendications précédentes,
**caractérisé en ce que**
la couche réfléchissante (25.1) est configurée de manière structurée et provoque une inversion de phase ou une réfraction de la lumière.

17. Agencement détecteur optique à lentille selon une des revendications 1 à 16,
**caractérisé en ce que**
la couche de lentille (25.2) est configurée de manière structurée et provoque une inversion de phase ou une réfraction de la lumière.

18. Agencement détecteur optique à lentille selon une des revendications précédentes,
**caractérisé en ce que**
la couche détectrice de rayonnement (22) est formée entre la couche de lentille (25.2) et la couche réfléchissante (25.1).

Fig.2

Fig.1

Fig.3

Fig. 4

40